Europäisches Patentamt

European Patent Office

Office européen des brevets

(11) Numéro de publication: **0 311 505**
**A1**

## DEMANDE DE BREVET EUROPEEN

(21) Numéro de dépôt: **88402504.0**

(22) Date de dépôt: **04.10.88**

(51) Int. Cl.⁴: **H 03 J 7/32**
**H 03 L 7/22**

(30) Priorité: **09.10.87 FR 8713966**

(43) Date de publication de la demande:
**12.04.89 Bulletin 89/15**

(84) Etats contractants désignés: **DE GB IT**

(71) Demandeur: **THOMSON-CSF**
**173, Boulevard Haussmann**
**F-75379 Paris Cédex 08 (FR)**

(72) Inventeur: **Bensadou, Jean-Claude**
**THOMSON-CSF SCPI 19, avenue de Messine**
**F-75008 Paris (FR)**

**Roullet, André**
**THOMSON-CSF SCPI 19, avenue de Messine**
**F-75008 Paris (FR)**

(74) Mandataire: **Lincot, Georges et al**
**THOMSON-CSF SCPI 19, avenue de Messine**
**F-75008 Paris (FR)**

(54) **Récepteur panoramique de radiosurveillance.**

(57) Le récepteur comprend une chaîne de réception radiofréquence formée par une antenne (1) couplée à au moins une tête
haute fréquence (2). La chaîne de réception est commandée
par un dispositif de vobulation (3) pour détecter le spectre
radiofréquence des signaux reçus par l'antenne (1) dans une
bande de fréquences déterminée. Un dispositif de visualisation
à écran cathodique (4) permet de faire apparaître le spectre
radiofréquence balayé par le dispositif de vobulation (3). Le
dispositif de vobulation agit sur au moins une boucle de
synthèse de fréquence numérique (23, 24). Il est commandé
numériquement par un processeur (5), à partir d'informations
de balayage en fréquence fournie par un panneau de
commande (6) lié au processeur.

Application : Détection et surveillance d'émissions radioélectriques dans des bandes de fréquences étendues.

FIG.1

EP 0 311 505 A1

**Description**

### Récepteur panoramique de radiosurveillance

La présente invention concerne un récepteur panoramique de radiosurveillance capable d'effectuer la détection et la visualisation dans une gamme de fréquences très étendues comprises par exemple, entre 20 MHz et 2,7 GHz, la présence d'émissions radioélectriques que celles-ci aient lieu en des temps plus ou moins brefs ou que leurs fréquences varient par paliers, lorsqu'il s'agit notamment d'émissions en évasion de fréquence.

Les récepteurs de radiosurveillance connus permettent, au moyen d'une exploitation manuelle effectuée par un opérateur, la visualisation d'émissions radioélectriques sur des écrans de type à rayons cathodiques. Ces récepteurs sont munis généralement de chaînes de transposition pilotées par un ou plusieurs oscillateurs qui transforment le signal reçu par l'antenne du récepteur en un signal de fréquence intermédiaire, et un dispositif de vobulation effectue une commande linéaire par rapport au temps de la fréquence de chaque oscillateur des boucles de transposition.

Cependant, du fait de la plage réduite de fonctionnement en fréquence des oscillateurs, il est nécessaire pour couvrir une large bande de fréquences avec une précision et une linéarité raisonnables d'effectuer plusieurs transpositions de fréquences au moyen de plusieurs oscillateurs à fréquences variables couvrant chacun une bande déterminée. Ceci donne lieu à des combinaisons multiples de fréquences d'où il résulte des signaux parasites qui se manifestent dans le plan de fréquences et faussent les observations. Egalement la réalisation du dispositif de vobulation, par des moyens analogiques, est souvent la cause du manque de linéarité de la loi fréquence-temps et d'une imprécision sur la valeur des fréquences détectées. D'autre part, la fréquence de chaque oscillateur doit être recalée constamment sur une valeur de référence pour compenser les effets de dérive.

Enfin, la conception entièrement analogique des récepteurs de radiosurveillance connus conduit à un mode d'exploration en fréquence très rigide où il n'est pas permis par exemple, de supprimer ou de masquer en cours d'exploration certaines gammes de fréquences dans le plan de fréquences du récepteur pour gagner en temps d'analyse, de même qu'il n'existe généralement pas dans ces récepteurs de dispositifs permettant la détection de fausses alarmes.

Le but de l'invention est de pallier les inconvénients précités.

A cet effet, l'invention a pour objet, un récepteur panoramique de radiosurveillance du type comprenant, une chaîne de réception radiofréquence comportant au moins une antenne couplée à au moins une tête haute fréquence commandée par un dispositif de vobulation, pour détecter le spectre radiofréquence des signaux reçus par l'antenne dans une bande de fréquences déterminée et un dispositif de visualisation à écran cathodique pour visualiser le spectre radiofréquence balayé par le dispositif de vobulation caractérisé en ce qu'il comprend un synthétiseur de fréquence numérique commandé par un processeur à partir d'informations de balayage en fréquence fournies par un panneau de commande lié au processeur.

D'autres caractéristiques et avantages de l'invention apparaîtront ci-après à l'aide de la description qui va suivre faite en regard des dessins annexés qui représentent :

- la figure 1 un schéma de principe du récepteur de radiosurveillance selon l'invention ;
- la figure 2 un schéma de réalisation de la tête haute fréquence du récepteur de la figure 1 ;
- la figure 3 un schéma de réalisation du synthétiseur de fréquence de la figure 1 ;
- la figure 4 un schéma de réalisation d'une boucle de synthèse pour l'élaboration d'une fréquence de référence $F_r$ entrant dans la composition du synthétiseur à trois boucles de la figure 3 ;
- la figure 5 un schéma de réalisation de la boucle de synthèse petit pas du synthétiseur représenté à la figure 3 ;
- la figure 6 un schéma de réalisation de la boucle de synthèse grand pas du synthétiseur représenté à la figure 3 ;
- la figure 7 un mode de réalisation de la boucle d'addition du synthétiseur à trois boucles représenté à la figure 3 ;
- la figure 8 le schéma d'un dispositif de vobulation ;
- la figure 9 un organigramme pour le traitement des fausses alarmes ;
- la figure 10 un graphe représentatif de la courbe de probabilité d'avoir à l'entrée du récepteur une amplitude de bruit déterminée pour obtenir un seuil de détection réglable défini à partir d'un taux de fausses alarmes déterminé.

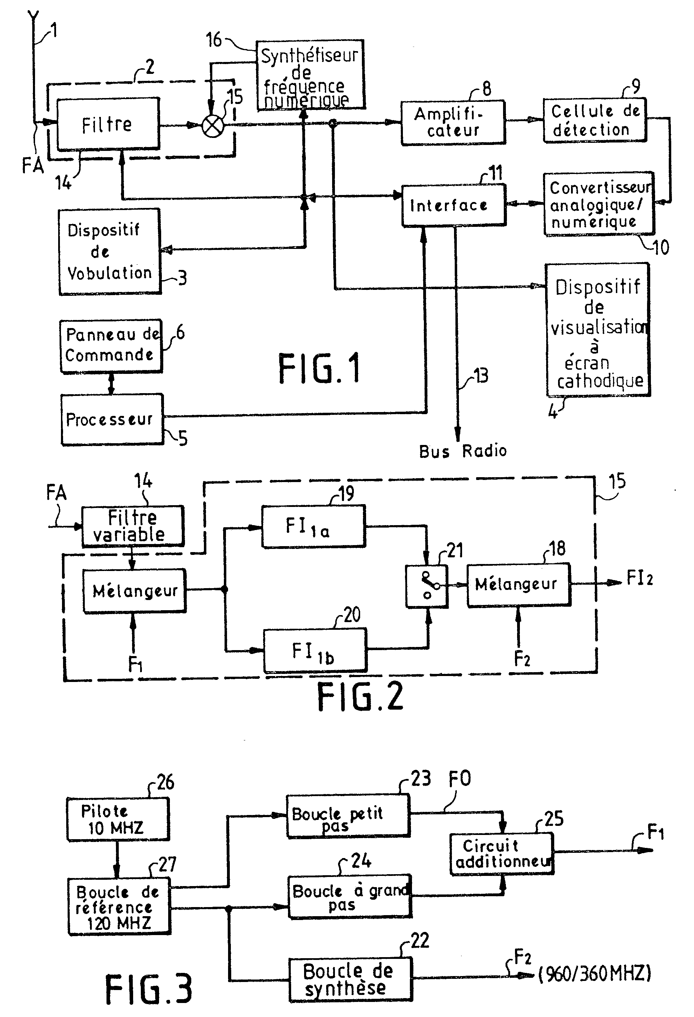

Le récepteur de radiosurveillance représenté à la figure 1 comprend au moins une antenne 1 couplée à au moins une tête haute fréquence 2 représentée à l'intérieur d'une ligne en pointillés, qui est commandée par un dispositif de vobulation 3. Le spectre de fréquence des signaux reçus par l'antenne 1 et détectés par l'action du dispositif de vobulation 3 sur la tête haute fréquence 2 sont visualisés par un dispositif de visualisation à écran cathodique 4. Le dispositif de vobulation 3 est commandé numériquement à partir d'un processeur 5 constitué par un microprocesseur ou tout autre dispositif équivalent recevant des ordres d'un panneau de commande 6. Les signaux obtenus en sortie de la tête haute fréquence 2 et vobulés par le dispositif de vobulation 3 sont transmis d'une part, directement au dispositif de visualisation 4 et d'autre part, à un circuit d'interface 11 au travers d'un amplificateur logarithmique 8, d'une cellule de détection 9, d'un convertisseur analogique-numérique 10, l'ensemble des éléments 8 à 11 étant reliés en série. Le circuit d'interface 11 assure

2

l'interface entre le processeur 5, la tête haute fréquence 2, le dispositif de vobulation 3, le convertisseur analogique-numérique 10, le dispositif de visualisation 4 et un bus radio 13 utilisable pour la transmission éventuelle de commandes vers d'autres dispositifs d'émission réception extérieurs, non représentés. La tête haute fréquence 2 comprend un filtre variable 14, couplé à l'entrée d'un dispositif de transposition de fréquence 15 excité par un synthétiseur de fréquence numérique 16 comprenant au moins une boucle de synthèse de fréquence numérique, pour transposer en fréquence et filtrer les signaux obtenus en sortie de la tête haute fréquence 2.

Le dispositif de transposition de fréquence 15 de la tête haute fréquence qui est représentée à la figure 2 se compose de deux étages mélangeurs de fréquences 17 et 18 liés entre eux par des filtres à fréquences intermédiaires 19 et 20 branchés tous deux à une sortie d'un étage mélangeur de fréquences 17. Un dispositif d'aiguillage 21 permet le branchement du mélangeur 18, soit à la sortie du filtre 19, soit à la sortie du filtre 20. Les filtres 19 et 20 sont accordés respectivement sur des fréquences intermédiaires $FI_{1a}$ et $FI_{1b}$ , ces fréquences résultent du battement d'un signal fréquence FA reçu par l'antenne au travers un filtre variable 14 accordé sur la fréquence FA et d'un signal de vobulation de fréquence $F_1$ produit par le synthétiseur 16. L'intérêt de ce montage est qu'il permet d'obtenir des réceptions de signaux dans une plage étendue de fréquence avec une excursion en fréquence de l'étage de vobulation relativement réduite. A titre d'exemple, pour une bande de réception comprise entre 20 MHz et 2,7 GHz, l'excursion en fréquence de l'étage de vobulation peut être réduite à environ 772 MHz en choisissant des fréquences intermédiaires $FI_a$ et $FI_b$ à 981,4 et 381,4 MHz.

Les deux fréquences intermédiaires $FI_{1a}$ et $FI_{1b}$ sont ensuite transposées en une fréquence intermédiaire unique au moyen de l'étage mélangeur 18 excité, soit par un signal de fréquence $F_2$ à 960 MHz, ou par un signal de fréquence $F_2$ à 360 MHz permettant d'obtenir dans cet exemple une fréquence intermédiaire $FI_2$ de 21,4 MHz.

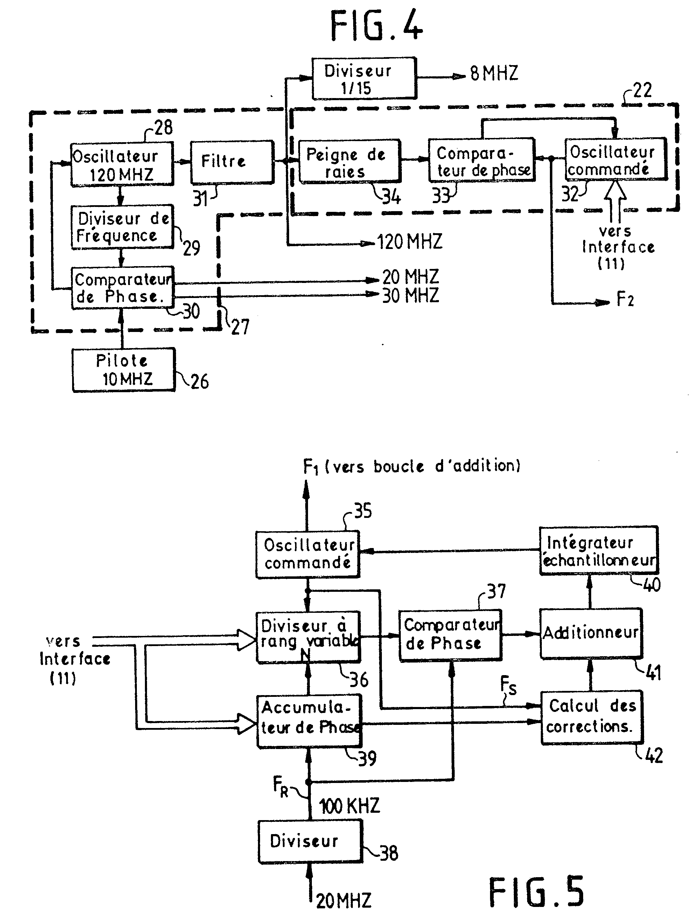

Le synthétiseur 16 selon l'invention permettant d'élaborer les fréquences $F_1$ et $F_2$ est représenté à la figure 3. Il comprend, une boucle de synthèse 22 permettant d'élaborer la fréquence $F_2$ et un ensemble de deux boucles de synthèse 23 et 24 respectivement à pas de synthèse réduit dénommés boucle à petit pas sur la figure 3 et une boucle à grand pas, couplées à un circuit additionneur de fréquence 25 sur la sortie duquel est prélevée à la fréquence $F_1$. L'ensemble est piloté à partir d'un oscillateur pilote 26 accordé sur 10 MHz par exemple, et d'une boucle de référence de fréquence 27. Des détails de réalisation correspondant à la boucle de synthèse 22 et de la boucle de référence 27 sont montrés à la figure 4 à l'intérieur de lignes en pointillés portant les mêmes références. La boucle de référence en fréquence 27 comprend un oscillateur à quartz 28 qui dans le cadre de l'exemple décrit précédemment est accordé à une fréquence égale à 120 MHz, un diviseur de fréquence 29, un circuit comparateur de phase 30, et un filtre à quartz 31.

L'oscillateur à quartz 28 est verrouillé en phase sur l'oscillateur pilote 26. Le diviseur de fréquence 29 divise la fréquence de l'oscillateur 28 pour fournir des signaux de fréquences 20 et 30 MHz utilisés pour permettre le fonctionnement des boucles de synthèse 23 et 24.

Le signal de fréquence $F_2$ est fourni par la boucle de synthèse 22 composée d'un oscillateur 32 commandé en tension, couplé, de façon connue, à un comparateur de phase 33 qui effectue une comparaison de phase entre la phase fournie par la sortie de l'oscillateur 32 et celle d'un signal de même fréquence fournie par un générateur de peigne de raies 34. La fréquence de l'oscillateur 32 est prépositionnée sur les fréquences 960 ou 360 MHz par le microprocesseur 5 de la figure 1.

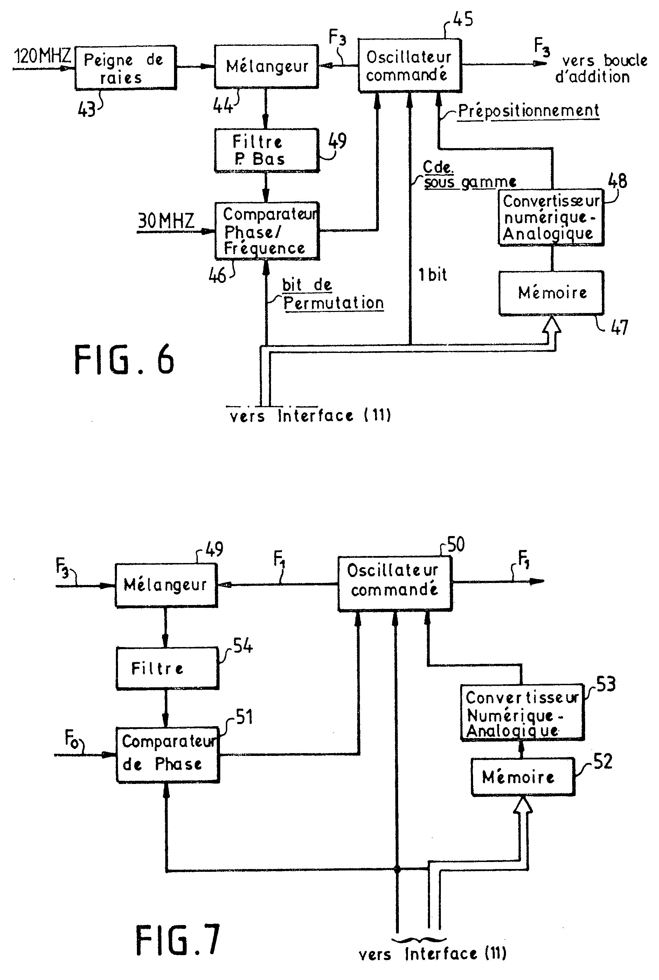

La boucle de synthèse 23 à pas réduit est représentée à la figure 5. Elle comprend de façon connue, telle que décrite par exemple dans la demande de brevet français n° 83 20844 déposée au nom de la Demanderesse, un oscillateur commandé en tension 35 de fréquence variable $F_0$ couplé à un diviseur à rang variable 36. Un comparateur de phase 37 assure une comparaison de phase entre le signal de fréquence divisée, fourni par le diviseur programmable 36 et un signal de référence fréquence $F_R$ fourni à la sortie d'une diviseur de fréquence 38. Le comparateur de phase 37 commande un circuit intégrateur-échantillonneur 40 au travers d'un circuit additionneur 41. Le circuit additionneur 41 est d'autre part relié à un circuit de correction 42 pour compenser l'erreur de phase qui apparaît à la sortie du comparateur de phase 37 à partir du contenu de l'accumulateur de phase 39.

La division effectuée par le diviseur à rang variable 36 a lieu sur M cycles de durée égale chacun à la période du signal de référence de fréquence $F_R$. Au cours de ces M cycles la fréquence de l'oscillateur 35 est divisée F fois par $M+1$ et M-F fois par N où N désigne le rapport de division du diviseur 36. Dans ces conditions la fréquence synthétisée $F_S$ obtenue à la sortie de l'oscillateur vérifie la relation

$$F_S = F_R \cdot \frac{F \cdot (N+1) + (M-F) \cdot N}{M} \qquad (1)$$

soit $F_S = F_R \cdot (N + M/F)$ (2)
ou $F_S = F_R \cdot N'$ (3)
avec $N' = N + F/M$ (4)
F/M étant la partie fractionnaire du rang de division par N.

3

EP 0 311 505 A1

Sans synthèse fractionnaire la relation (2) se réduit à

$F_S = F_R \times N$

Avec synthèse fractionnaire la relation (2) devient

$F_S/M < F_R$ ou bien $F_S/M + 1 > F_R$

Il apparaît à chaque comparaison de phase une erreur à la sortie du comparateur de phase 37. Cette erreur est compensée via le circuit additionneur 41 et le circuit de calcul de correction 42 par l'accumulateur de phase 39 qui contient sous forme numérique l'erreur de phase créée à chaque comparaison.

La boucle de synthèse des grands pas 24 est représentée à la figure 6. Elle comprend, un générateur de peigne de raies 43 (les raies du peigne étant régulièrement espacées, l'espacement pouvant éventuellement être égal à 120 MHz), un circuit mélangeur de fréquence 44, un oscillateur commandé en tension 45 de fréquence variable $F_3$, un comparateur phase fréquence 46, une mémoire morte programmable 47, un convertisseur numérique-analogique 48 et un filtre passe-bas 49.

L'oscillateur 45 est positionné sur une fréquence égale à un multiple P de l'espacement des raies du peigne, soit éventuellement à P fois 120 MHz à ±30 MHz. Les fréquences de calage de l'oscillateur 45 sont mémorisées dans la mémoire morte programmable 47 et adressée par le bus radio 13. Chaque mot de fréquence lu dans la mémoire 47 est décodé en tension par le convertisseur numérique-analogique 48 de façon à caler l'oscillateur 45 sur la fréquence correspondante.

Le signal de fréquence $F_3$ fourni par l'oscillateur 45 est mélangé dans le circuit mélangeur 44 au peigne de raies fourni par le circuit 43 pour créer des battements avec les différents harmoniques du peigne. Dans le cas d'un fonctionnement de l'oscillateur 45 sur une fréquence égale à P fois 120 MHz à ±30 MHz l'harmonique le plus proche en fréquence sera un battement à 30 MHz. Le battement en fréquence est sélectionné par le filtre passe-bas 49 et est appliqué par ce dernier sur une entrée du comparateur de phase 46 qui reçoit sur une deuxième entrée un signal de référence de fréquence égale à celle du battement le plus proche. La tension d'erreur qui est obtenue à la sortie du comparateur 46 permet de stabiliser la fréquence de l'oscillateur tout en améliorant son spectre par recopie de celui de l'harmonique du peigne de raies sur lequel la boucle s'asservit.

Un bit de permutation est appliqué par le processeur 5 sur une entrée de commande du comparateur de phase 46 lorsqu'il y a inversion du signe du mélange par le mélangeur 44 et permettre la convergence de la boucle. Cet artifice multiplie par deux le nombre de fréquences créées et donne par exemple un espacement entre canaux de 60 MHz lorsque la fréquence de l'oscillateur correspond à un multiple de 120 MHz à ±30 MHz. Dans ce cas les harmoniques utilisés vont du rang 7 au rang 15 (de 840 à 1800 MHz) fournissant ainsi des fréquences de 870 à 1830 MHz au pas de 60 MHz avec un temps de positionnement de boucle de synthèse inférieur à 200 microsecondes.

La boucle d'addition qui est représentée à la figure 7 comprend des éléments similaires au plan des fonctionnalités à ceux de la figure 6 à la différence cependant qu'elle est privée du générateur de peigne de raies 43. De la sorte, les éléments similaires de la figure 6 sont représentés sur la figure 7 avec des références augmentées de 5. L'oscillateur 50 sur la figure 7 est commandé par une mémoire morte programmable 52 au travers d'un convertisseur numérique-analogique 53. Dans le cadre des exemples numériques cités précédemment, la plage de fréquences couverte par l'oscillateur 50 peut aller de 1001,4 à 1731 MHz. La fréquence fournie par l'oscillateur est mélangée dans le mélangeur 49 avec le signal de fréquence $F_3$ fourni par l'oscillateur 45 de la boucle des grands pas.

Selon le cas, la fréquence $F_1$ fournie par l'oscillateur 50 est supérieure ou inférieure à la fréquence $F_3$ du signal fourni par l'oscillateur 45. Dans le cadre des exemples numériques cités précédemment le battement entre ces deux signaux est toujours compris entre 120 et 150 MHz. Le signal de fréquence $F_0$ fourni par l'oscillateur 35 de la boucle des petits pas est comparé à ce battement. La tension d'erreur résultante verrouille en phase l'oscillateur 50 de façon que la relation $F_1 = F_3 \pm F_0$ soit toujours vérifiée. Afin d'obtenir le fonctionnement correct de la boucle d'addition, la fréquence de l'oscillateur 50 est prépositionnée en utilisant la même méthode que celle de la boucle de synthèse des grands pas 24.

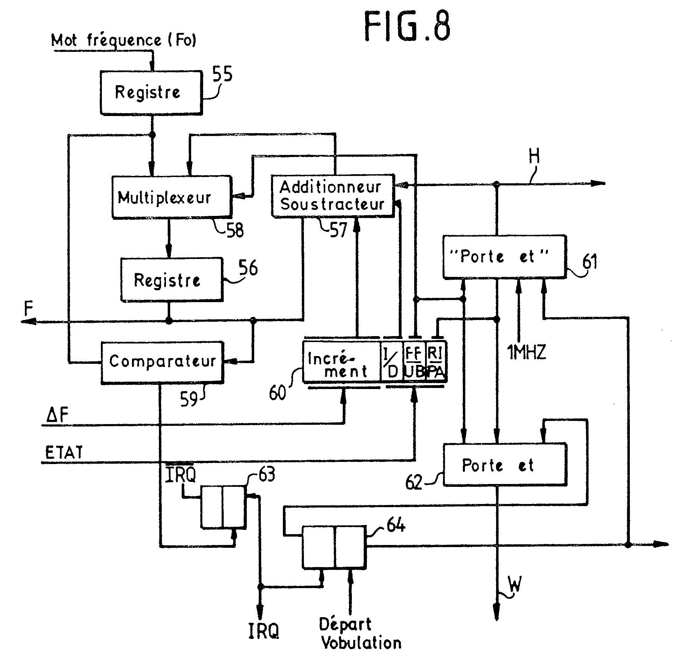

La boucle de synthèse des petits pas 23 est vobulée par le dispositif de vobulation qui est représenté à la figure 8. Ce circuit comprend un registre primaire 55, un registre secondaire 56 et un circuit additionneur-soustracteur 57. Les sorties des circuits additionneurs 57 et du registre primaire 55 sont couplées aux entrées du registre secondaire 56 au travers d'un circuit multiplexeur 58. Un circuit comparateur 59 est relié aux sorties du registre primaire 55 et du registre secondaire 56 pour comparer les contenus de ces deux registres. Le circuit de la figure 8 comprend également un registre 60, une porte ET 61, une porte ET 62 et des basculeurs 63 et 64. Le registre 60 mémorise l'incrément de fréquence $\Delta f$ programmé au panneau de commande 6 et transmis par le processeur 5, ainsi que des mots d'états également transmis par le processeur 5 par l'intermédiaire du circuit d'interface 11 pour commander le processus de vobulation et l'exploration en fréquence du récepteur. Le registre secondaire 56 et le circuit additionneur-soustracteur 57 constituent le circuit accumulateur du dispositif de vobulation. En début de cycle, le registre 56 est chargé par un mot binaire correspondant à une fréquence de départ $F_D$ puis son contenu est augmenté ou diminué au rythme d'un signal d'horloge de fréquence égale à 1 MHz par exemple de la valeur $\Delta F$ trouvée dans le registre 60 qui est fonction de la vitesse de vobulation demandée. De la sorte, en cours de vobulation, le mot binaire contenu dans le registre 56 correspond à une fréquence F qui est égale à $F_D \pm K . \Delta F$.

Dans le cadre de l'application numérique décrite précédemment F et $F_D$ sont compris entre 120 et 150 MHz. L'incrément $\Delta F$ correspond à un multiple entier du pas de 100 Hz et sa valeur maximale est fixée à 50 KHz. Le comparateur 59 et les basculeurs 63 et 64 constituent un circuit d'arrêt automatique du dispositif de

4

vobulation de la figure 8. Lorsque le mot de fréquence calculé par le circuit accumulateur (56, 57) du dispositif de vobulation est égal au mot représentant une fréquence d'arrêt stockée au préalable dans le registre 55, le circuit comparateur 59 fournit un signal qui bloque l'horloge à 1 MHz de progression du circuit accumulateur (56, 57) par l'intermédiaire de la porte 61 du circuit de vobulation. La fréquence d'arrêt peut par exemple être une des fréquences bornes à 120 et 150 MHz indiquées précédemment et qui correspondent soit, à une inversion du sens de vobulation sur la boucle à pas réduit 23, l'incrément devenant décrément et réciproquement ; soit, à un changement de prépositionnement des boucles de synthèse 24 et d'addition 25. Un autre groupe de fréquences d'arrêt peut être formé par des fréquences marqueurs situées le plus souvent entre les fréquences bornes mais qui sont alors conditionnées par le traitement effectué au niveau du récepteur si celui-ci prévoit par exemple une surbrillance sur la trace du tube à rayon cathodique. Une autre fréquence d'arrêt peut être constituée par une fréquence d'arrivée déterminée par rapport à la fréquence de départ, c'est-à-dire celle qui constitue l'autre extrémité de la gamme radiofréquence qui est balayée et visualisée par le récepteur de radiosurveillance. Le temps d'arrêt est alors fixé par la gestion du récepteur.

La commande du dispositif de vobulation de la figure 8 est effectuée au moyen d'une succession de mots transmis par le microprocesseur 5, au travers du circuit d'interface 11 ces mots étant des mots de fréquence, d'incrément et d'état. Un mot de fréquence est formé par un nombre déterminé d'octets qui sont transmis au registre primaire de fréquence 55 lorsqu'il s'agit d'indiquer au circuit de vobulation une fréquence de départ ou une fréquence d'arrêt d'un des types définis précédemment. Le mot incrément comprend également un nombre déterminé d'octets représentant la valeur de l'incrément de fréquence $\Delta F$. Ils sont transmis au registre d'incrément et d'état 60. Enfin le mot d'état est transmis avec le mot d'incrément au registre 60. Ce mot d'état comprend trois bits, un bit I/D pour positionner en mode incrémental ou décrémental l'additionneur-soustracteur 57, un bit FF/VB pour définir le fonctionnement en fréquence fixe ou en vobulation, un bit RI/PA pour commander le fonctionnement du récepteur en mode d'interception ou en récepteur panoramique de radiosurveillance.

Le dispositif de vobulation de la figure 8 fournit en retour vers l'extérieur, une demande d'interruption IRQ transmis par l'intermédiaire du basculeur 63, une horloge de balayage H fournit par la sortie de la porte ET 61, un signal d'interruption de balayage W fourni par la sortie de la porte ET 62 ce signal étant validé par un état du bit RI/PA.

Le mot de fréquence nécessaire à la commande de la boucle de synthèse à pas réduit de la figure 5 est appliqué en bloc par la sortie du registre 56 sur les entrées de l'accumulateur de phase 39 et du diviseur à rang variable 36, ceci afin d'éviter des sauts de phase dans la boucle de synthèse. Ceci est obtenu par l'intermédiaire du registre secondaire de fréquence 56 dont la capacité est identique à celle du registre primaire de fréquence 55 et dans lequel on transfère en un seul coup d'horloge le contenu du registre primaire 55. Ce transfert est synchrone avec l'horloge de référence de la partie synthèse. Le registre 56 sert aussi de registre accumulateur pour le dispositif de vobulation. Le circuit multiplexeur 58 permet d'effectuer l'aiguillage de l'entrée du registre secondaire 56 vers la sortie du registre primaire 55 ou vers la sortie du circuit additionneur-soustracteur 57 sous la commande du bit d'état FF/VB. Le circuit comparateur 59 détecte l'égalité des contenus des registres primaire et secondaire 55 et 56 et compare à chaque instant le mot de fréquence obtenu en sortie du registre 56 au mot de fréquence d'arrêt stocké dans le registre primaire de fréquence 55. La bascule 63 est commandée par le complément de l'horloge à 1 MHz, celle-ci recopie l'état de la sortie du comparateur 59 pour s'affranchir des parasites dûs aux différents taux de propagation dans le comparateur. La sortie de la bascule 63 sert à créer le signal de demande d'interruption IRQ indiquant au microprocesseur 5 que la fréquence d'arrêt a été atteinte. Il permet également de désarmer la bascule 64 qui est armée à chaque départ de vobulation commandé par le microprocesseur 5. Lorsque la bascule 64 est armée celle-ci autorise la transmission de l'horloge 1 MHz vers le circuit additionneur-soustracteur 57 au travers de la porte ET 61. Lorsque la bascule 64 est désarmée un signal W est transmis au moyen de la porte ET 62 pour interrompre le balayage du récepteur panoramique. Les signaux H et W ne sont validés que si les commandes FF/VB et RI/PA sont à 1 logique.

Dans ces conditions à chaque fois que le synthétiseur de la boucle à pas réduit de la figure 5 a atteint une fréquence d'arrivée qui peut être une des bornes 120 ou 150 MHz, il s'arrête et attend de nouvelles instructions. Les boucles grand pas 24 et d'addition 25 sont ensuite repositionnées pour changer de canal de fréquence. Une fois que ce repositionnement est terminé un nouveau balayage en fréquence de 30 MHz s'effectue pendant lequel la boucle d'addition 25 suit les variations de fréquence fournies par la boucle des pas réduits 24. Une gamme très étendue de fréquences, peut ainsi être parcourue par des balayages discontinus de bandes d'amplitude 30 MHz, chaque bande étant séparée de la suivante par un temps mort de 200 microsecondes environ, pour permettre le transfert d'informations sur le bus radio 13 entre le processeur 5 et les boucles de synthèse 22 à 25 et positionner les boucles rapides grand pas 24 et d'addition 25 décrites précédemment.

L'intérêt de cette disposition est qu'elle permet d'effectuer des balayages sur un nombre important de sous-gammes de fréquences dont les bornes sont préalablement programmées avec un pas de balayage également programmé. Ce mode de balayage est particulièrement adapté à la recherche d'émissions nouvelles, lorsque par exemple dans des applications militaires il s'agit de remonter le plan des fréquences d'un réseau ennemi. Naturellement la mise en oeuvre d'un microprocesseur pour réaliser le processeur 5 permet d'envisager des modes de balayage automatique, semi-automatique, manuel pour effectuer la recherche de ces fréquences. Mais il permet également, grâce à l'utilisation des registres primaire et secondaire 55 et 56 du circuit de vobulation de la figure 8, d'améliorer la rapidité du fonctionnement du récepteur, grâce à la possibilité qu'il y a de masquer certaines fréquences non intéressantes du plan de fréquences, pour détecter plus rapidement des émissions nouvelles où il est inutile de perdre du temps à balayer des fréquences ou des émissions étendues de télévision par exemple, déjà repérées et réputées amies.

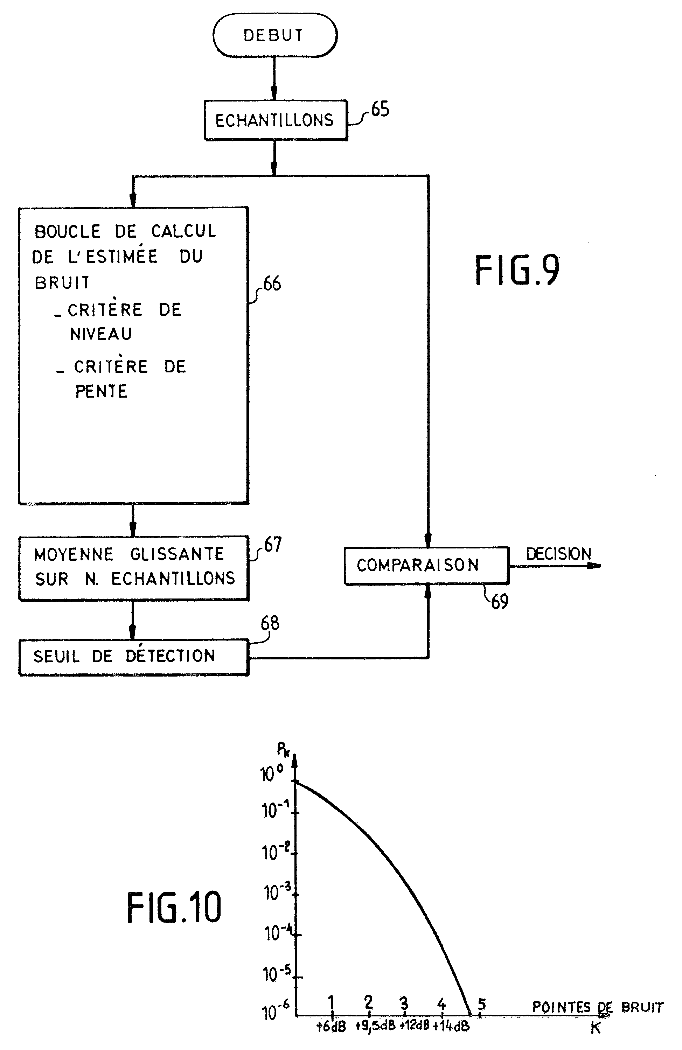

Un autre intérêt qu'il y a d'utiliser un processeur est qu'il offre un moyen particulièrement simple pour permettre la détection d'émissions inconnues pour lesquelles il n'est pas possible a priori de définir un seuil de détection précis à cause du bruit radioélectrique atmosphérique qui entache normalement toute réception radioélectrique. Ce problème peut être résolu par une programmation appropriée du processeur 5 pour calculer en permanence une estimée du bruit ambiant afin de définir un seuil de détection au-dessus de ce bruit en fonction du taux de fausses alarmes qui est jugé acceptable par l'exploitant du récepteur. Un programme correspondant peut être réalisé de la façon représentée par l'organigramme de la figure 9.

Suivant cet organigramme, le processeur 5 prélève, à l'étape représentée en 65, les échantillons de signal fournis par le convertisseur analogique-numérique 10 de la figure 1 afin de discriminer, lors d'une seconde étape 66, les échantillons représentatifs soit d'un signal utile, soit d'un bruit atmosphérique. La discrimination est éventuellement réalisée, soit en prenant comme premier critère, un critère de niveau pour comparer chaque échantillon reçu à un niveau de seuil déterminé correspondant à une valeur actuelle déjà estimée du bruit, soit encore, en suivant un deuxième critère consistant à suivre l'évolution de l'amplitude des échantillons transmis au processeur 5.

Suivant le premier critère, chaque échantillon est comparé à une valeur connue actuelle du bruit et si le niveau de l'échantillon recueilli est supérieure à un nombre déterminé de décibels, le processeur 5 classe cet échantillon comme appartenant à un signal utile. Dans le cas contraire, si le niveau de l'échantillon recueilli est inférieur à un nombre déterminé de décibels alors cet échantillon est considéré comme un échantillon de bruit atmosphérique.

Pour appliquer le deuxième critère, le processeur 5 mesure la pente d'évolution du signal. Si la pente est faible le processeur 5 assimile le signal appliqué à son entrée à du bruit atmosphérique, par contre, si la pente est forte le signal d'entrée est considéré comme étant dû à un signal utile.

L'utilisation du premier et du deuxième critère permet de ne pas prendre en compte les échantillons qui correspondent aux signaux utiles pour ne pas fausser le calcul de l'estimation du bruit.

Le calcul de l'estimée de bruit s'effectue ensuite selon une troisième étape référencée 67 qui consiste à effectuer une moyenne sur un nombre déterminé d'échantillons de bruit détectés.

Ce calcul permet de définir la probabilité pour que l'amplitude instantanée du bruit dépasse d'un nombre déterminé de décibels la valeur estimée du bruit calculé précédemment, ce qui permet de définir, suivant l'étape représentée en 68, le seuil de détection en fonction du taux de fausses alarmes acceptable par le récepteur.

Enfin, à l'étape 69, une comparaison permet en fonction du seuil qui est déterminé à l'étape 68, de comparer la valeur de chaque échantillon à la valeur du seuil défini précédemment et d'identifier de façon précise chaque échantillon reçu comme étant un échantillon purement de bruit ou un échantillon de signal utile.

La détermination du seuil de détection est illustré par le diagramme de la figure 10 qui représente une courbe de probabilité P(x) d'avoir à l'entrée du récepteur une amplitude de bruit x déterminée, à partir d'une puissance de bruit σ2 présent dans la bande réception.

Cette loi de probabilité est généralement définie par une relation de la forme

$$P_k = 1 - \frac{1}{\sqrt{2 . \pi}} \int_{-\infty}^{k} e^{-\frac{k^2}{2}} . dk$$

C'est-à-dire la probabilité de détecter à tort un signal utile au delà d'un seuil S de bruit.

Cependant la valeur du seuil qui est ainsi déterminée ne permet pas d'éliminer à elle seule des détections de parasites impulsionnels. Pour pallier cet inconvénient le processeur 5 peut encore être judicieusement programmé pour qu'en cours de balayage du plan de fréquence à surveiller par le récepteur de radiosurveillance, un arrêt de balayage pendant un intervalle de temps τ déterminé se produise sur la fréquence du signal dont l'amplitude dépasse le seuil de détection, en échantillonnant le signal et en comptant, durant la période τ d'arrêt du balayage, le nombre de fois où le niveau du signal détecté est supérieur au seuil de détection.

La discrimination d'un signal par rapport à un parasite est dès lors simple à obtenir, le processeur 5 pouvant comparer le nombre d'occurrences obtenues à un nombre déterminé préalablement enregistré. A titre d'exemple un rapport de 7/10 pourra être jugé suffisant pour discriminer l'arrivée d'un signal utile d'un parasite.

**Revendications**

1. Récepteur panoramique de radiosurveillance du type comprenant une chaîne de réception radiofréquence comportant au moins une antenne (1) couplée à au moins une tête hautefréquence (2) commandée par un dispositif de vobulation (3) pour détecter le spectre radiofréquence des signaux reçus par l'antenne (1) dans une bande de fréquences déterminée et un dispositif de visualisation à écran cathodique (4) pour visualiser le spectre radiofréquence balayé par le dispositif de vobulation caractérisé en ce qu'il comprend un synthétiseur de fréquence numérique (16) commandé par un processeur (5), à partir d'informations de balayage en fréquence fournies par un panneau de commande (6) lié au processeur (5).

2. Récepteur selon la revendication 1 caractérisé en ce que le synthétiseur de fréquence numérique comprend deux boucles de synthèse à pas de fréquence imbriqués, une boucle de synthèse à pas réduit (23) et une boucle de synthèse à grand pas (24), les deux boucles étant toutes deux reliées à un circuit additionneur de fréquences (25), les pas des deux boucles étant calibrés de façon que l'ensemble des pas de la boucle à pas réduit (23) soit contenu à l'intérieur d'un pas de fréquence de la boucle de synthèse à grand pas (24).

3. Récepteur selon l'une quelconque des revendications 1 et 2 caractérisé en ce que la boucle de synthèse à pas réduit est formée par un synthétiseur numérique à division fractionnaire comprenant un oscillateur (35) commandé en tension couplé à un circuit diviseur de fréquence à rang variable (36), un circuit comparateur de phase (37) couplé par une première entrée au circuit diviseur de fréquence (36) et recevant sur une deuxième entrée un signal de fréquence de référence ($F_R$), ainsi qu'un circuit additionneur (41) couplé par une première entrée en sortie du circuit comparateur de phase (37) et par une deuxième entrée à un circuit accumulateur de phase (39) chargé avec la partie fractionnaire du nombre diviseur appliqué à la boucle de synthèse, pour commander la tension appliquée à l'oscillateur (35) et compenser l'erreur de phase obtenu en sortie du circuit comparateur de phase (37).

4. Récepteur selon la revendication 3 caractérisé en ce qu'il comprend un dispositif de vobulation (3) pour incrémenter le rang du circuit diviseur à rang variable, et augmenter d'une quantité déterminée le contenu du circuit accumulateur (39) au rythme d'une horloge de fréquence déterminée.

5. Récepteur selon la revendication 4 caractérisé en ce que le dispositif de vobulation (3) commande l'excursion en fréquence de la boucle de synthèse à pas réduit (23) depuis une fréquence de départ $F_D$ jusqu'à une fréquence d'arrivée par incréments de fréquence successifs, les fréquences de départ et d'arrivée et l'incrément de fréquence pouvant être programmé à volonté à partir du panneau de commande (6).

6. Récepteur selon l'une quelconque des revendications 1 à 5 caractérisé en ce que la boucle de synthèse à grand pas (24) comprend une boucle à verrouillage de phase composée par un oscillateur commandé en tension (45) et un comparateur de phase (46) pour asservir la fréquence de l'oscillateur (45) sur des fréquences particulières fournies par un générateur de peigne de raies (43), à partir de fréquences de consigne programmées à partir du panneau de commande (6).

7. Récepteur selon l'une quelconque des revendications 1 à 6 caractérisé en ce que le processeur (5) peut être programmé à partir du panneau de commande (6) pour commander des balayages en fréquences du dispositif de vobulation (3) sur un nombre déterminé de sous-gammes de fréquences éventuellement disjointes.

8. Récepteur selon l'une quelconque des revendications 1 à 7, caractérisé en ce que le processeur (5) calcule (65 ... 70) en permanence une estimée du bruit ambiant pour discriminer en permanence à partir d'un taux de fausse alarme déterminé; les signaux reçus dûs à des émissions inconnues, des signaux générés par le bruit atmosphérique.

## FIG.1

## FIG.2

## FIG.3

# FIG.4

Diviseur
1/15 → 8 MHZ

22

Oscillateur
120 MHZ  28

Filtre
31

Peigne de
raies  34

Comparateur de phase  33

Oscillateur
commandé  32

vers
Interface
(11)

Diviseur de
Fréquence  29

→ 120 MHZ

Comparateur
de Phase.  30  27

→ 20 MHZ
→ 30 MHZ
→ F₂

Pilote
10 MHZ  26

---

F₁ (vers boucle d'addition)

Oscillateur
commandé  35

Intégrateur
échantillonneur  40

vers
Interface
(11)

Diviseur à
rang variable
N  36

Comparateur
de Phase  37

Additionneur  41

Accumulateur de Phase  39

F_S

Calcul des
corrections.  42

F_R

100 KHZ

Diviseur  38

20 MHZ

# FIG.5

FIG. 6

120MHZ → Peigne de raies (43) → Mélangeur (44) → Filtre P. Bas (49)

30MHZ → Comparateur Phase/Fréquence (46)

F₃ → Oscillateur commandé (45) → F₃ vers boucle d'addition

Prépositionnement

Cde. sous gamme

Convertisseur numérique-Analogique (48)

Mémoire (47)

bit de Permutation

1 bit

vers Interface (11)

FIG. 7

F₃ → Mélangeur (49) → Filtre (54) → Comparateur de Phase (51)

F₀ → Comparateur de Phase (51)

F₁ → Oscillateur commandé (50) → F₁

Convertisseur Numérique-Analogique (53)

Mémoire (52)

vers Interface (11)

# FIG.8

DEBUT

ECHANTILLONS — 65

BOUCLE DE CALCUL
DE L'ESTIMÉE DU
BRUIT — 66
- CRITÈRE DE
NIVEAU
- CRITÈRE DE
PENTE

**FIG.9**

MOYENNE GLISSANTE
SUR N. ECHANTILLONS — 67

COMPARAISON → DECISION — 69

SEUIL DE DÉTECTION — 68

**FIG.10**

$P_k$

$10^0$
$10^{-1}$
$10^{-2}$
$10^{-3}$
$10^{-4}$
$10^{-5}$
$10^{-6}$

1    2    3    4    5    POINTES DE BRUIT
+6dB  +9,5dB  +12dB  +14dB                K

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| X | EP-A-0 058 934 (ROHDE & SCHWARZ) * Page 6, ligne 30 - page 9, ligne 34; figure * | 1 | H 03 J 7/32 H 03 L 7/22 |
| Y | --- | 2-4,6-8 | |
| X | US-A-4 501 020 (WAKEMAN) * Colonne 8, ligne 14 - colonne 10, ligne 39; figures 3-6 * --- | 1 | |
| Y | ELECTRONIQUE INDUSTRIELLE, no. 52, 1 mai 1983, pages 55-59, Paris, FR; J.-F. BIJONNEAU: "Un synthétiseur 1,3 GHz à haute pureté spectrale" * En entier * --- | 2,6 | |
| Y | EP-A-0 147 307 (THOMSON-CSF) * Page 4, lignes 13-34; page 10, lignes 10-30; page 26, lignes 18-21; figures 3-5 * --- | 3,4 | |
| Y | US-A-3 449 749 (W.J. McEVOY) * Colonne 1, lignes 11-26; colonne 3, ligne 18 - colonne 9, ligne 62; figures 1-8 * --- | 7 | **DOMAINES TECHNIQUES RECHERCHES (Int. Cl.4)** H 03 J H 03 L G 01 R |
| Y | EP-A-0 077 248 (THOMSON-CSF) * Page 2, ligne 29 - page 12, ligne 12; figures 1-3 * --- | 8 | |
| A | TECHN. MITT. AEG-TELEFUNKEN, vol. 66, no. 2/3, 1976, pages 106-108; J. EHMANN: "Programmierbare Frequenzband-Überwachungsanlage AFR 1500" * En entier * ----- | 5 | |

Le présent rapport a été établi pour toutes les revendications

| Lieu de la recherche | Date d'achèvement de la recherche | Examinateur |
|---|---|---|
| LA HAYE | 13-01-1989 | BALBINOT H. |